# EUROPEAN PATENT APPLICATION

(11) **EP 1 837 668 A1**
(43) Date of publication of application: **26.09.2007**
(21) Application number: 05809363.4
(22) Date of filing: 24.11.2005
(51) Int. Cl.: G01R 31/317, H01L 27/04

(54) **SEMICONDUCTOR DEVICE, TEST APPARATUS AND MEASURING METHOD**

(30) Priority: 06.01.2005 JP 2005001711
(71) Applicant: ADVANTEST CORPORATION, Nerima-ku, Tokyo 179-0071 (JP)
(72) Inventor: YAMAZAKI, Makoto, ADVANTEST CORPORATION, Tokyo 1790071 (JP); MATSUMURA, Hidenobu, ADVANTEST CORPORATION, Tokyo 1790071 (JP); FURUKAWA, Yasuo, ADVANTEST CORP., Tokyo 1790071 (JP)
(74) Representative: Pfenning, Meinig & Partner GbR
(86) International application number: PCT/JP2005/021591
(87) International publication number: WO 2006/073028

(57) **Abstract**

A semiconductor device for measuring delay time of a wiring under test provided therein is provided, in which the semiconductor device includes: a loop path on which the wiring under test is provided; a delay element for delaying an input signal by a predetermined time; a delay selecting unit for determining whether or not the delay element is connected on the loop path; a loop delay measuring unit for measuring delay time of the loop path; a first gate delay estimating unit for estimating delay time of the delay element by subtracting delay time of the loop path in case the delay element is not connected on the loop path from delay time of the loop path in case the delay element is connected on the loop path; a second gate delay estimating unit for estimating delay time of a logic circuit connected on the loop path on the basis of the delay time of the delay element; and a wiring delay estimating unit for estimating delay time of the wiring under test.

## Description

### TECHNICAL FIELD

The present invention relates to a semiconductor device, a testing apparatus, and a measuring method. More particularly, the present invention relates to a semiconductor device, a testing apparatus, and a measuring method for measuring delay time of a wiring under test provided therein. The present application relates to the following Japanese application, the contents of which are incorporated herein by reference if applicable.
A Japanese Patent Application No. 2005-001711 Filed on January 6, 2005.

### BACKGROUND ART

Conventionally, delay time for signal transmission of a semiconductor integrated circuit is caused principally by elements such as a transistor and a MOSFET provided inside a semiconductor silicon substrate and less affected by wiring delay. With respect to this, a technique for measuring delay time of an element provided in a semiconductor device and delaying an input clock signal by a desirable time using delay of a signal due to the element to output the delayed clock signal as a timing signal is known (for example, see Japanese Patent No. 3499051).

### DISCLOSURE OF THE INVENTION

### PROBLEMS TO BE SOLVED BY THE INVENTION

However, recently, according to progress of high speed and high density of semiconductors, wiring delay due to a product of wiring resistance and coupling capacitance between a substrate and insulating material should not be disregarded. Further, it is attempted to improve manufacture process of the semiconductor by using copper of lower resistance or insulating material of a lower dielectric constant as the wiring material. However, since the insulating material of a low dielectric constant is porous, irregularity of dielectricity is easy to be caused and a delay characteristic of wiring of the inside is different between semiconductor devices and irregular for each region of the inside of a semiconductor device. Thus, it is highly demanded to measure delay time of each wiring provided inside the semiconductor device for every region. However, a method for measuring wiring delay accurately is not proposed.

Therefore, it is an object of the present invention to provide a semiconductor device, a testing apparatus, and a measuring method, which are capable of overcoming the above drawbacks accompanying the conventional art. The above and other objects can be achieved by combinations described in the independent claims. The dependent claims define further advantageous and exemplary combinations of the present invention.

### MEANS FOR SOLVING THE PROBLEMS

According to the first aspect of the present invention, a semiconductor device for measuring delay time of a wiring under test provided therein includes: a loop path on which the wiring under test is provided; a delay element for delaying an input signal by a predetermined time; a delay selecting unit for determining whether or not the delay element is connected on the loop path; a loop delay measuring unit for measuring delay time of the loop path; a first gate delay estimating unit for estimating delay time of the delay element by subtracting delay time of the loop path in case the delay element is not connected on the loop path from delay time of the loop path in case the delay element is connected on the loop path; a second gate delay estimating unit for estimating delay time of a logic circuit connected on the loop path on the basis of the delay time of the delay element regardless of whether or not the delay element is connected on the loop path; and a wiring delay estimating unit for estimating delay time of the wiring under test on the basis of the delay time of the loop path and the delay time of the logic circuit.

The semiconductor device may further include a memory for storing a reference value of delay time of each of the delay element and the logic circuit, and a delay ratio estimating unit for estimating a ratio of actual delay time of the delay element, which is estimated by the first gate delay estimating unit, to the reference value of delay time of the delay element, and the second gate delay estimating unit may estimate actual delay time of the logic circuit by multiplying the reference value of the logic circuit by the ratio estimated by the delay ratio estimating unit. The wiring under test may produce delay time larger than the delay time of the delay element. Each of wirings other than the wiring under test included in the loop path may produce delay time smaller than the delay time of the delay element.

The loop path may include a path under test which has the wiring under test and is used when delay time of the wiring under test is measured; and another path which is different from the path under test, and the semiconductor device may further include a switching gate for determining whether or not a signal output from the another path is output to the path under test. The semiconductor device may further include a phase difference detecting unit for detecting phase difference between an output signal of the delay element and an input signal of the delay element; a driving voltage control unit for controlling a driving voltage of the delay element so that the phase difference can be a predetermined value; and a driving voltage control inhibiting unit for inhibiting the control of the driving voltage when delay time of the wiring under test is measured. The semiconductor device may further include a phase difference detecting unit for detecting phase difference between an output signal of the delay element and an input signal of the delay element; and a driving voltage control unit for controlling a driving voltage of the delay element so that the phase difference can be a predetermined value, and the driving voltage control unit may further control a driving voltage of the logic circuit by the driving voltage of the delay element.

According to the second aspect of the present invention, a semiconductor device for measuring delay time of a wiring under test provided therein includes: a loop path on which the wiring under test is provided; a substrate bias control unit for applying a plurality of substrate bias voltages, which are different from each other, to a logic circuit connected on the loop path; a loop delay measuring unit for measuring delay time of the loop path; and a wiring delay estimating unit for estimating delay time of the wiring under test on the basis of the delay time of a plurality of loop paths corresponding to the plurality of the substrate bias voltages.

According to the third aspect of the present invention, a semiconductor device for measuring delay time of a wiring under test provided therein includes: a loop path; a path selecting unit for connecting one of the wiring under test and another wiring on the loop path; a loop delay measuring unit for measuring delay time of the loop path; and a delay time estimating unit for estimating delay time of the wiring under test on the basis of delay time of the loop path in case the wiring under test is connected on the loop path and delay time of the loop path in case the another wiring is connected on the loop path. The semiconductor device may further include a first delay time estimating unit for estimating delay time by subtracting the delay time of the loop path in case the another wiring is connected on the loop path from the delay time of the loop path in case the wiring under test is connected on the loop path; a memory for storing a reference value of delay time of the another wiring; and a second delay time estimating unit for estimating delay time of the wiring under test by adding the reference value of delay time of the another wiring to the delay time estimated by the first delay time estimating unit.

According to the fourth aspect of the present invention, a testing apparatus for testing a device under test includes: a pattern generating unit for generating a pattern of a test signal which is to be provided to the device under test; a timing generating unit for generating a timing signal which is an input pulse signal delayed by a predetermined time by a delay element; a waveform forming unit for forming a waveform of the test signal on the basis of the pattern and the timing signal; a driver for providing the device under test with the test signal; a comparator for outputting a logic value which is the result of comparing an output signal output from the device under test in response to the test signal with a reference voltage; and a logic comparing unit for determining pass/fail of the device under test by comparing the logic value with an expectation value, in which the timing generating unit includes: a loop path on which the wiring under test is provided; a delay element; a delay selecting unit for determining whether or not the delay element is connected on the loop path; a loop delay measuring unit for measuring delay time of the loop path; a first gate delay estimating unit for estimating delay time of the delay element by subtracting delay time of the loop path in case the delay element is not connected on the loop path from delay time of the loop path in case the delay element is connected on the loop path; a second gate delay estimating unit for estimating delay time of a logic circuit connected on the loop path on the basis of the delay time of the delay element regardless of whether or not the delay element is connected on the loop path; and a wiring delay estimating unit for estimating delay time of the wiring under test on the basis of the delay time of the loop path and the delay time of the logic circuit.

According to the fifth aspect of the present invention, a method for measuring delay time of a wiring under test provided inside includes: a loop path setting step of setting a loop path on which the wiring under test is provided; a delay selecting step of determining whether or not the delay element is connected on the loop path; a loop delay measuring step of measuring delay time of the loop path; a first gate delay estimating step of estimating delay time of the delay element by subtracting delay time of the loop path in case the delay element is not connected on the loop path from delay time of the loop path in case the delay element is connected on the loop path; a second gate delay estimating step of estimating delay time of a logic circuit connected on the loop path on the basis of the delay time of the delay element regardless of whether or not the delay element is connected on the loop path; and a wiring delay estimating step of estimating delay time of the wiring under test on the basis of the delay time of the loop path and the delay time of the logic circuit.

According to the sixth aspect of the present invention, a method for measuring delay time of a wiring under test provided inside includes: a loop path setting step of setting a loop path on which the wiring under test is provided; a substrate bias control step of applying a plurality of substrate bias voltages, which are different from each other, to a logic circuit connected on the loop path; a loop delay measuring step of measuring delay time of the loop path; and a wiring delay estimating step of estimating delay time of the wiring under test on the basis of the delay time of a plurality of loop paths corresponding to the plurality of the substrate bias voltages.

According to the seventh aspect of the present invention, a method for measuring delay time of a wiring under test provided inside includes: a path selecting step of connecting one of the wiring under test and another wiring on a loop path; a loop delay measuring step of measuring delay time of the loop path; and a delay time estimating step of estimating delay time of the wiring under test on the basis of delay time of the loop path in case the wiring under test is connected on the loop path and delay time of the loop path in case the another wiring is connected on the loop path.

The summary of the invention does not necessarily describe all necessary features of the present invention. The present invention may also be a sub-combination of the features described above.

### EFFECT OF THE INVENTION

According to the present invention, it is possible to accurately measure delay time of a wiring provided inside a semiconductor device.

### BRIEF DESCRIPTION OF THE DRAWINGS

Fig. 1 is a block diagram showing an example of the configuration of a testing apparatus 10 according to an embodiment of the present invention.
Fig. 2 shows a first example of the configuration of a timing generating unit 40 according to an embodiment of the present invention.
Fig. 3 is a flowchart showing an example of the flow of processing by the first example of the timing generating unit 40 according to the embodiment of the present invention.
Fig. 4 shows a second example of the configuration of the timing generating unit 40 according to an embodiment of the present invention.
Fig. 5 shows a third example of the configuration of the timing generating unit 40 according to an embodiment of the present invention.
Fig. 6 shows an example of a signal transmitted by a loop path included in the timing generating unit 40 according to an embodiment of the present invention.
Fig. 7 shows a correlation between a result of measurement of delay time of a loop path by a loop delay measuring unit 345 according to an embodiment of the present invention and the threshold value of voltage of a logic circuit connected on the loop path.
Fig. 8 is a flowchart showing an example of the flow of processing by the third example of the timing generating unit 40 according to the embodiment of the present invention.
Fig. 9 shows a fourth example of the configuration of the timing generating unit 40 according to an embodiment of the present invention.
Fig. 10 is a flowchart showing an example of the flow of processing by the fourth example of the timing generating unit 40 according to the embodiment of the present invention.

### BEST MODE FOR CARRYING OUT THE INVENTION

The invention will now be described based on the preferred embodiments, which do not intend to limit the scope of the present invention, but exemplify the invention. All of the features and the combinations thereof described in the embodiment are not necessarily essential to the invention.

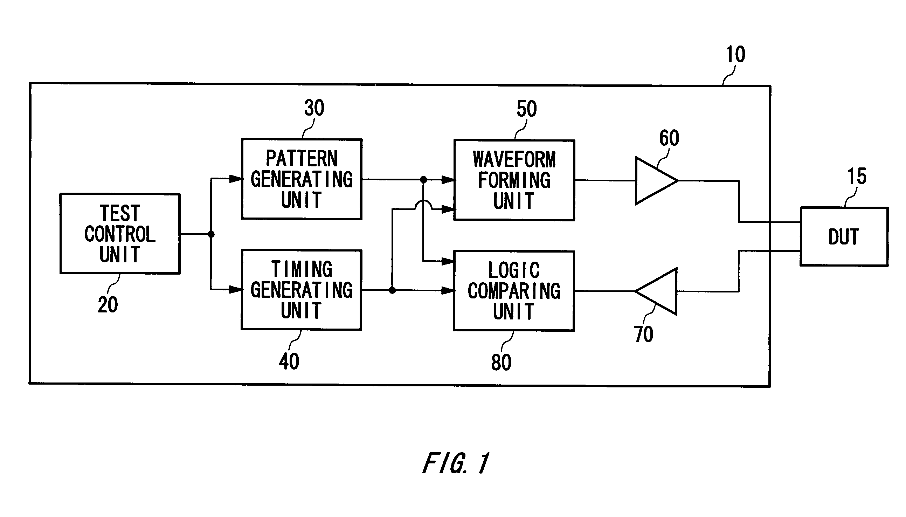

Fig. 1 is a block diagram showing an example of the configuration of a testing apparatus 10 according to an embodiment of the present invention. According to the present embodiment, the testing apparatus 10 provides a device under test ("DUT") 15 with a predetermined test signal and tests the DUT 15 by comparing an output signal output from the DUT 15 in response to the test signal with an expectation value.

The testing apparatus 10 includes a test control unit 20, a pattern generating unit 30, a timing generating unit 40, a waveform forming unit 50, a driver 60, a comparator 70, and a logic comparing unit 80. The test control unit 20 controls each unit of the testing apparatus 10 and makes the testing apparatus 10 performs a testing on the DUT 15. For example, the test control unit 20 generates a clock signal for controlling operation of each unit of the testing apparatus 10. Then, the test control unit 20 outputs the generated clock signal to the pattern generating unit 30 and the timing generating unit 40. The pattern generating unit 30 generates a pattern of the test signal to be provided to the DUT 15 on the basis of the clock signal received from the test control unit 20. Then, the pattern generating unit 30 outputs the generated pattern to the waveform forming unit 50. Further, the pattern generating unit 30 further generates an expectation value corresponding to the generated pattern. Then, the pattern generating unit 30 outputs the generated expectation value to the logic comparing unit 80. The timing generating unit 40 generates a timing signal obtained by delaying the clock signal received from the test control unit 20 by a predetermined time by a delay element. Then, the timing generating unit 40 outputs the generated timing signal to the waveform forming unit 50 and the logic comparing unit 80.

The waveform forming unit 50 forms a waveform of the test signal on the basis of the pattern of the test signal received from the pattern generating unit 30 and the timing signal received from the timing generating unit 40. Then, the waveform forming unit 50 outputs the test signal of which waveform is formed to the driver 60. The driver 60 provides the DUT 15 with the test signal received from the waveform forming unit 50. The comparator 70 compares an output signal output from the DUT 15 in response to the test signal provided to the DUT 15 by the driver 60 with a reference voltage. Then, the comparator 70 outputs a logic value which is the comparison result to the logic comparing unit 80. The logic comparing unit 80 compares the logic value which is the comparison result received from the comparator 70 with the expectation value received from the pattern generating unit 30 on the basis of the timing signal received from the timing generating unit 40. Then, the logic comparing unit 80 determines that the DUT 15 is a failure in case the logic value which is the comparison result does not coincide with the expectation value.

As above, the testing apparatus 10 according to the present embodiment can test the DUT 15. Further, the testing apparatus 10 according to the present embodiment can measure delay time of the wiring under test provided inside the semiconductor device which is the timing generating unit 40. In the following, measurement of delay time of the wiring under test in the timing generating unit 40 is described.

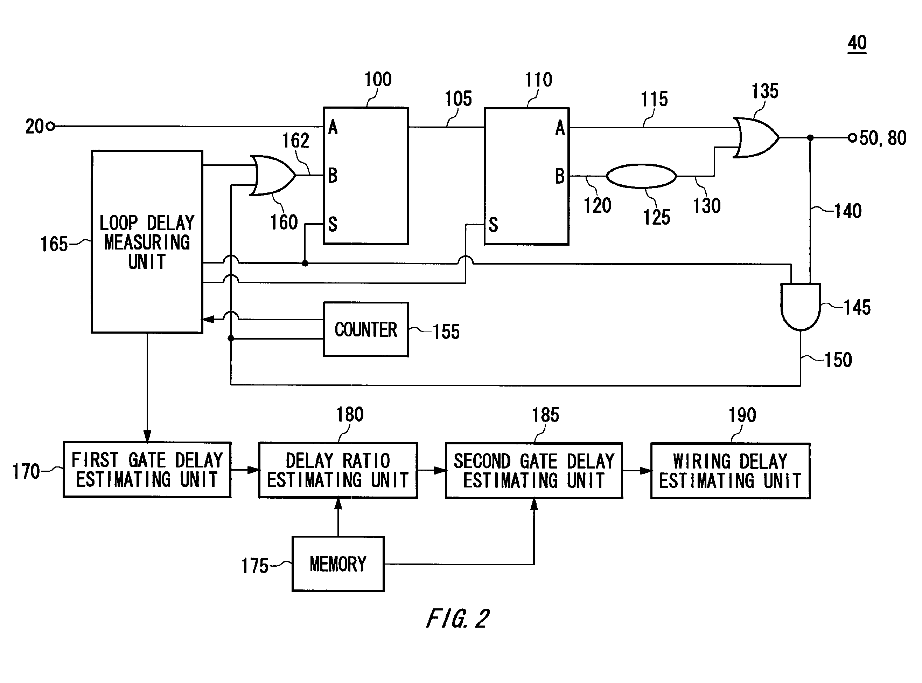

Fig. 2 shows a first example of the configuration of the timing generating unit 40 according to the embodiment of the present invention. According to the present example, the timing generating unit 40 measures delay time of a wiring under test 150 provided therein. The timing generating unit 40 according to the present example includes a signal selecting unit 100, a first wiring 105, a delay selecting unit 110, a second wiring 115, a third wiring 120, a delay element 125, a fourth wiring 130, a first OR gate 135, a fifth wiring 140, a switching gate 145, a wiring under test 150, a counter 155, a second OR gate 160, a loop delay measuring unit 165, a first gate delay estimating unit 170, a memory 175, a delay ratio estimating unit 180, a second delay estimating unit 185, and a wiring delay estimating unit 190.

The timing generating unit 40 uses a loop path on which the wiring under test 150 is provided in case of measuring delay time of the wiring under test 150. Here, the loop path consists of the signal selecting unit 100, the first wiring 105, the delay selecting unit 110, the second wiring 115, the first OR gate 135, the fifth wiring 140, the switching gate 145, the wiring under test 150, the second OR gate 160, and a sixth wiring 162. Further, the loop path may include the third wiring 120, the delay element 125, and the fourth wiring 130 instead of the second wiring 115.

In case of testing the DUT 15, the signal selecting unit 100 selects a clock signal received from the test control unit 20. Then, the signal selecting unit 100 outputs the selected clock signal to the delay selecting unit 110 via the first wiring 105. The delay selecting unit 110 is connected with the signal selecting unit 100 by the first wiring 105 and outputs the clock signal received from the signal selecting unit 100 to the first OR gate 135 via a path formed by the second wiring 115 or a path consisting of the third wiring 120, the delay element 125, and the fourth wiring 130. The delay element 125 is connected with the delay selecting unit 110 by the third wiring 120 and delays the clock signal received from the delay selecting unit 110 by a predetermined time. Then, the delay element 125 outputs the delayed signal to the first OR gate 135 via the fourth wiring 130. The first OR gate 135 outputs OR between the signal received from the delay selecting unit 110 via the second wiring 115 and the signal received from the delay element 125 via the fourth wiring 130 to the waveform forming unit 50 and the logic comparing unit 80 as a timing signal showing timing of outputting the pattern signal. As above, the timing generating unit 40 can control delay by which the timing signal is delayed with respect to the clock signal according to which path the delay selecting unit 110 uses to output a signal.

In the meantime, in case of measuring delay time of the wiring under test 150, the signal selecting unit 100 selects a signal received from the second OR gate 160. The delay selecting unit 110 outputs the signal received from the signal selecting unit 100 to the first OR gate 135 via the path formed by the second wiring 115 or the path consisting of the third wiring 120, the delay element 125, and the fourth wiring 130. By this, in case of measuring delay time of the wiring under test 150, the delay selecting unit 110 can select whether or not the delay element 125 is connected on the loop path. The delay element 125 delays the input signal received from the delay selecting unit 110 by a predetermined time. The first OR gate 135 outputs OR between the signal received from the delay selecting unit 110 via the second wiring 115 and the signal received from the delay element 125 via the fourth wiring 130 to the switching gate 145 via the fifth wiring 140.

The switching gate 145 outputs AND between the signal received from the first OR gate 135 via the fifth wiring 140 and the signal received from the loop delay measuring unit 165 to the wiring under test 150. The counter 155 is connected to the wiring under test 150 and counts the number of pulses included in the signal received from the wiring under test 150. Then, the counter 155 outputs the counted pulse number to the loop delay measuring unit 165. The second OR gate 160 outputs OR between the signal received from the switching gate 145 via the wiring under test 150 and the signal received from the loop delay measuring unit 165 to the signal selecting unit 100 via the sixth wiring 162.

The loop delay measuring unit 165 measures each of delay time for signal transmission of the loop path in case the delay element 125 is connected on the loop path and that in case the delay element 125 is not connected on the loop path. Then, the loop delay measuring unit 165 outputs the respective measurement result to the first gate delay estimating unit 170. The first gate delay estimating unit 170 estimates delay time of the delay element 125 by subtracting the delay time for signal transmission of the loop path in case the delay element 125 is not connected on the loop path from the delay time for signal transmission of the loop path in case the delay element 125 is connected on the loop path. Then, the first gate delay estimating unit 170 outputs the estimated delay time of the delay element 125 to the delay ratio estimating unit 180.

The memory 175 stores reference values of delay time of the delay element 125 and each of logic circuits connected on the loop path regardless whether or not the delay element 125 is connected on the loop path. According to the present example, the logic circuit includes the signal selecting unit 100, the delay selecting unit 110, the first OR gate 135, the switching gate 145, and the second OR gate 160. Further, the reference value of delay time may be a design standard value predetermined according to the number of stages of the delay element 125 or a plurality of gates constituting the logic circuit, for example. The delay ratio estimating unit 180 estimates a ratio of the actual delay time of the delay element 125 estimated by the first gate delay estimating unit 170 to the reference value of delay time of the delay element 125 stored in the memory 175. Then, the delay ratio estimating unit 180 outputs the estimated ratio of delay time and the delay time of the loop path to the second gate delay estimating unit 185.

The second gate delay estimating unit 185 estimates delay time of a logic circuit connected on the loop path on the basis of the delay time of the delay element 125 estimated by the first gate delay estimating unit 170 regardless of whether or not the delay element 125 is connected on the loop path. More specifically, the second gate delay estimating unit 185 may estimate actual delay time of the logic circuit by multiplying the reference value of delay time of the logic circuit stored in the memory 175 by the ratio of delay time estimated by the delay ratio estimating unit 180. The wiring delay estimating unit 190 estimates delay time of the wiring under test on the basis of the delay time of the loop path measured by the loop delay measuring unit 165 and the delay time of the logic circuit connected on the loop path. More specifically, the wiring delay estimating unit 190 may estimate delay time of the wiring under test 150 by subtracting the delay time of the delay element 125 and delay time of each of other delay circuits connected on the loop path from the delay time of the loop path in case the delay element 125 is connected on the loop path. Instead, the wiring delay estimating unit 190 may estimate delay time of the wiring under test 150 by subtracting delay time of each of delay circuits connected on the loop path other than the delay element 125 from the delay time of the loop path in case the delay element 125 is not connected on the loop path.

In case delay time of a path including a wiring under test and a gate is measured, there is a large difference between the measurement result and delay time of the wiring under test due to large delay time of the gate. However, as described above, according to the timing generating unit 40 of the present embodiment, it is possible to eliminate delay time due to a logic circuit from delay time of the loop path to estimate delay time of the wiring under test 150.

Further, delay time of a gate including a semiconductor device is determined mainly by delay time of a transistor constituting the gate and the delay time of the transistor depends on a manufacturing device of the semiconductor device. Thus, a ratio of actual delay time to a reference value is substantially equal between gates included in a semiconductor device. Therefore, according to the timing generating unit 40 of the present embodiment, it is possible to accurately estimate an actual delay time of a logic circuit other than the delay element 125 connected on the loop path on the basis of the ratio of an actual delay time of the delay element 125 to a reference value. By this, it is possible to accurately estimate delay time of the wiring under test 150 included in delay time of the whole loop path.

Further, according to the present example, the loop path includes the wiring under test 150 used to and consists of a path under test and another path which is different from the path under test. Here, the path under test consists of the wiring under test 150, the second OR gate 160, and the sixth wiring 162. Further, the path other than the path under test consists of the signal selecting unit 100, the first wiring 105, the delay selecting unit 110, the second wiring 115 or the third wiring 120, the delay element 125, and the fourth wiring 130, the first OR gate 135, and the fifth wiring 140. Further, the switching gate 145 determines whether a signal output from the path other than the path under test is output to the path under test according to the signal received from the loop delay measuring unit 165. More specifically, the switching gate 145 does not output the signal output from the path other than the path under test to the path under test in case of receiving L logic from the loop delay measuring unit 165. Further, the switching gate 145 outputs the signal output from the path other than the path under test to the path under test in case of receiving H logic from the loop delay measuring unit 165. By this, since the L logic is output to the switching gate 145 from the loop delay measuring unit 165 in case delay time of the wiring under test 150 is not measured and thus current may not flow through the wiring under test 150, it is possible to prevent electric power from being wasted.

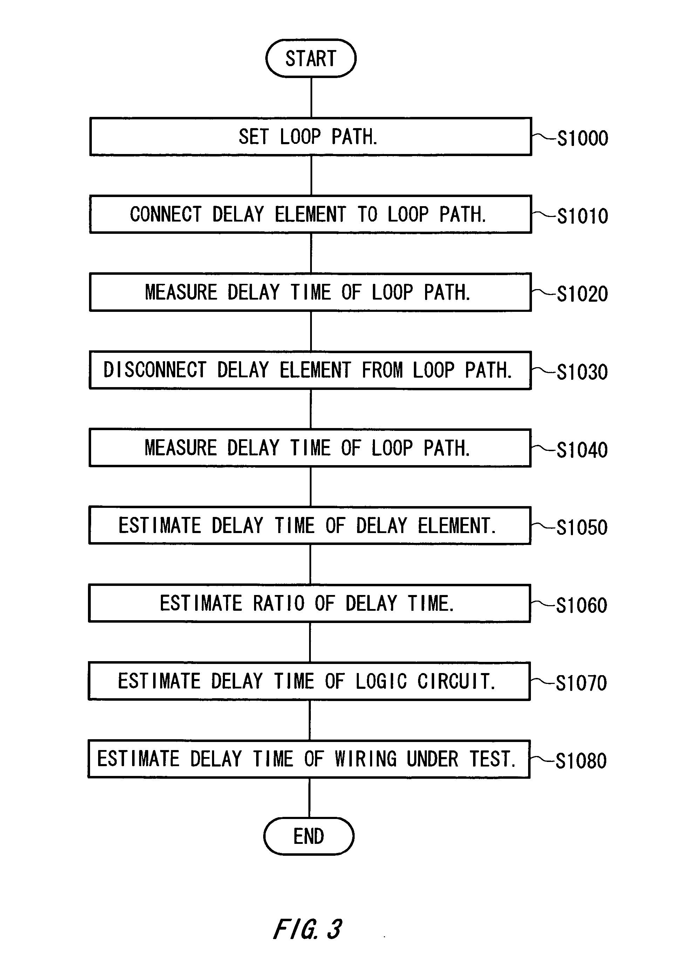

Fig. 3 is a flowchart showing an example of the flow of processing by the first example of the timing generating unit 40 according to the present embodiment. First, the loop delay measuring unit 165 sets a loop path (S1000). More specifically, the loop delay measuring unit 165 controls a signal which is to be output to the signal selecting unit 100 and makes the signal selecting unit 100 select a signal output from the second OR gate 160. Then, the loop delay measuring unit 165 further controls a signal which is to be output to the switching gate 145 and makes the switching gate 145 output a signal output from the first OR gate 135 to the wiring under test 150.

Then, the delay selecting unit 110 connects the delay element 125 on the loop path (S1010). More specifically, the loop delay measuring unit 165 controls a signal which is to be output to the delay selecting unit 110 and makes the delay selecting unit 110 output the signal received from the signal selecting unit 100 to the delay element 125 via the third wiring 120. Then, the loop delay measuring unit 165 measures delay time for signal transmission of the loop path (S1020). More specifically, the loop delay measuring unit 165 outputs pulses to the second OR gate 160 and makes the second OR gate 160 transmit the pulses to the loop path. Then, the loop delay measuring unit 165 estimates an oscillation frequency of the loop path on the basis of the result of counting the number of the pulses transmitted by the wiring under test 150 received from the counter 155. Then, the loop delay measuring unit 165 outputs an inverse number of the oscillation frequency as delay time of the loop path.

Then, the delay selecting unit 110 disconnects the delay element 125 from the loop path (S1030). More specifically, the loop delay measuring unit 165 controls a signal which is to be output to the delay selecting unit 110 and makes the delay selecting unit 110 output the signal received from the signal selecting unit 100 to the first OR gate 135 via the loop delay measuring unit 165. Then, the loop delay measuring unit 165 measures delay time of the loop path similarly with S1020 (S1040).

Then, the first gate delay estimating unit 170 estimates delay time of the delay element 125 by subtracting the delay time estimated in S1040 from the delay time estimated in S1020 (S1050). Then, the delay ratio estimating unit 180 estimates a ratio of delay time for the delay element 125 by dividing the delay time of the delay element 125 estimated by the first gate delay estimating unit 170 by the reference value of delay time of the delay element 125 stored in the memory 175 (S1060). Then, the second gate delay estimating unit 185 multiplies the reference value of delay time of a logic circuit connected on the loop path regardless of whether or not the delay element 125 is connected on the loop path, which is stored in the memory 175, by the ratio of delay time of the delay element 125 estimated by the delay ratio estimating unit 180 and thus estimates actual delay time of the logic circuit (S1070). Then, the wiring delay estimating unit 190 subtracts the delay time of the logic circuit estimated by the second gate delay estimating unit 185 from the delay time of the loop path measured in S1040 to estimate delay time of the wiring under test 150 (S1080). Instead, the wiring delay estimating unit 190 may estimate delay time of the wiring under test 150 by subtracting the delay time of the delay element 125 estimated by the first gate delay estimating unit 170 and the delay time of the logic circuit estimated by the second gate delay estimating unit 185 from the delay time of the loop path measured in S1040.

Further, it is preferable in order to estimate delay time of the wiring under test 150 more accurately that the wiring under test 150 produces sufficiently large delay time. For example, it is preferable that the wiring under test 150 produces delay time larger than that of the delay element 125. Further, for example, it is preferable that the wiring under test 150 produces delay time larger than an error in estimation of delay time of the delay element 125, which is determined on the basis the size of an error in measurement of delay time of the loop path in each of cases the delay element 125 is connected and not connected on the loop path. Further, for example, it is preferable that the wiring under test 150 produces delay time larger than an error in estimation of actual delay time of a logic circuit other than the delay element 125, which is determined on the basis the size of an error in estimation of delay time of the delay element 125.

Further, according to the present embodiment, the wiring delay estimating unit 190 subtracts the delay time of the logic circuit from the delay time of the whole loop path to estimate delay time of the wiring under test 150. Therefore, it is preferable in order for the wiring delay estimating unit 190 to estimate delay time of the wiring under test 150 accurately that each of wirings which are different from the wiring under test 150 produces sufficiently small delay time. Here, the wirings other than the wiring under test 150 are the first wiring 105, the second wiring 115, the third wiring 120, the fourth wiring 130, the fifth wiring 140, and the sixth wiring 162. For example, each of the wirings preferably produces delay time smaller than that of the delay element 125. Further, the wiring delay estimating unit 190 may estimate delay time of the wiring under test 150 by subtracting the delay time of the logic circuit and a reference value of delay time of the wiring other than the wiring under test 150, for example, a design standard value corresponding to the pattern length, from the delay time of the whole loop path. In other words, in case of the reference value of delay time of the wiring other than the wiring under test 150 is not subtracted from the delay time of the whole loop path, the wiring under test 150 preferably produces delay time larger than that of the wiring other than the wiring under test 150. Further, in case of the reference value of delay time of the wiring other than the wiring under test 150 is subtracted from the delay time of the whole loop path, the wiring under test 150 preferably produces delay time larger than, for example, the difference between the actual delay time of the wiring other than the wiring under test 150 and the reference value of delay time.

Further, according to the present embodiment, the wiring under test 150 may be provided throughout a semiconductor device which is the timing generating unit 40. Further, the wiring under test 150 may be provided in every region generated by dividing the semiconductor device into a plurality of regions. By this, the timing generating unit 40 can measure a characteristic of wiring delay which differs between regions by measuring delay time of the wiring under test 150 for every region.

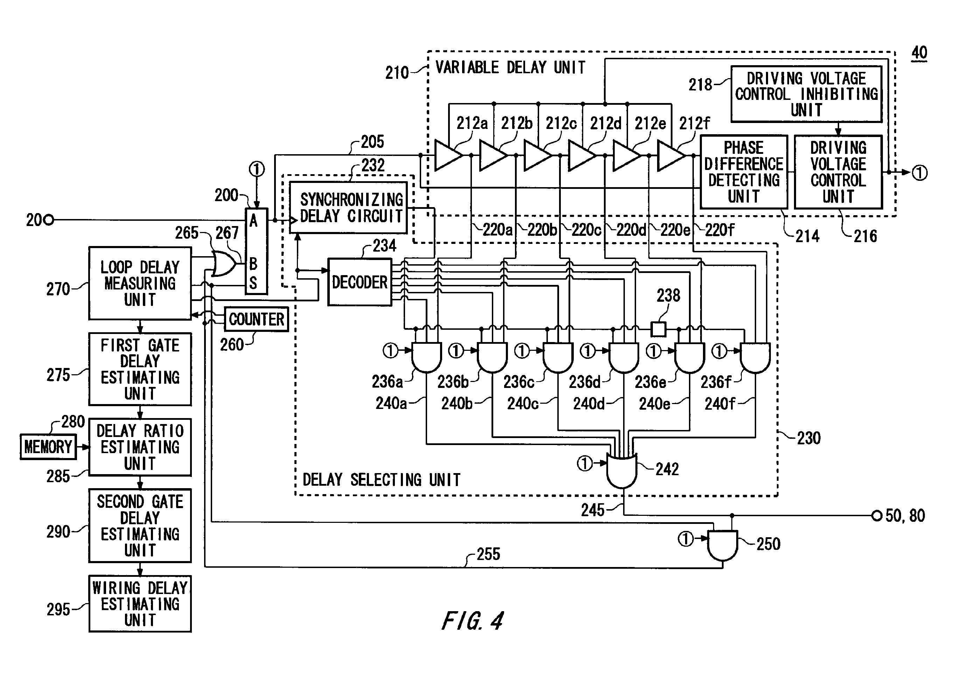

Fig. 4 shows a second example of the configuration of the timing generating unit 40 according to the present embodiment. According to the present example, the timing generating unit 40 measures delay time of a wiring under test 255 provided therein. According to the first example shown in Fig. 2, the timing generating unit 40 includes one delay element 125. However, the number of delay elements included in the timing generating unit 40 is not limited to one (1). In the present figure showing the second example, the timing generating unit 40 including a plurality of delay elements (212a~220f; hereinafter, referred to 212) is described.

The timing generating unit 40 according to the present example includes a signal selecting unit 200, a first wiring 205, a variable delay unit 210, a plurality of second wirings (220a~220f; hereinafter, referred to 220), a delay selecting unit 230, a fourth wiring 245, a switching gate 250, a wiring under test 255, a counter 260, a second OR gate 265, a fifth wiring 267, a loop delay measuring unit 270, a first gate delay estimating unit 275, a memory 280, a delay ratio estimating unit 285, a second gate delay estimating unit 290, and a wiring delay estimating unit 295.

The timing generating unit 40 uses a loop path on which the wiring under test 255 is provided in case of measuring delay time of the wiring under test 255. Here, the loop path consists of the signal selecting unit 200, the first wiring 205, at least a part of the plurality of delay elements 212, one of the second wirings 220, one of AND gates 236, one of third wirings 240, a first OR gate 242, the forth gate 245, the switching gate 250, the wiring under test 255, the second OR gate 265, and the fifth wiring 267.

In case of testing the DUT 15, the signal selecting unit 200 selects a clock signal received from the test control unit 20. Then, the signal selecting unit 200 outputs the selected clock signal to the variable delay unit 210 and the delay selecting unit 230 and thus makes the clock signal output to the waveform forming unit 50 and the logic comparing unit 80 as a timing signal delayed by a predetermined time.

In the meantime, in case of measuring delay time of the wiring under test 255, the signal selecting unit 200 selects a signal received from the second OR gate 265. Then, the signal selecting unit 200 outputs the selected signal to the variable delay unit 210 via the first wiring 205. Further, the signal selecting unit 200 outputs the selected signal to the delay selecting unit 230. The variable delay unit 210 includes the plurality of delay elements 212, a phase difference detecting unit 214, a driving voltage control unit 216, and a driving voltage control inhibiting unit 218. The plurality of delay elements 212 are provided on the loop path in series. Further, each of the plurality of delay elements 212 delays an input signal by a predetermined time. Then, each of the plurality of delay elements 212 outputs the delayed signal to the delay selecting unit 230 via the second wiring 220 connected with it. Therefore, as each of the plurality of delay elements 212 is provided at a post-stage, the delay element 212 outputs a signal delayed from the signal selected by the signal selecting unit 200 by a longer time. Thus, the delay element 212f which is provided at the last stage of the plurality of delay elements 212 outputs a delayed signal to the delay selecting unit 230 through the second wiring 220f and to the phase difference detecting unit 214.

The phase difference detecting unit 214 detects a phase difference between the output signal of the delay element 212f provided at the last stage and the input signal of the delay elements 212a provided at the first stage out of the plurality of delay elements 212. Then, the phase difference detecting unit 214 outputs a signal showing the detected phase difference to the driving voltage control unit 216. The driving voltage control unit 216 controls a driving voltage of each of the delay elements 212 so that the phase difference between the output signal and the input signal of the plurality of delay elements 212 detected by the phase difference detecting unit 214 may be a predetermined value.

The delay selecting unit 230 includes a synchronizing delay circuit 232, a decoder 234, a plurality of AND gates (236a~236f; hereinafter, referred to 236), a delay circuit 238, a plurality of third wirings (240a~240f; hereinafter, referred to 240), and the first OR gate 242. The synchronizing delay circuit 232 delays the signal selected by the signal selecting unit 200 by a delay time which is integer times as large as the period. Then, the synchronizing delay circuit 232 outputs the delayed signal to each of the plurality of AND gates 236. The decoder 234 controls a signal which is to be output to the plurality of AND gates 236 and thus selects one of the delay elements 212 from which signal is output to the first OR gate 242.

Each of the plurality of AND gates 236 outputs AND among the signal received from the delay element 212, the signal received from the synchronizing delay circuit 232, and the signal received from the decoder 234 to the first OR gate 242 via the third wiring 240 connected with it. In case the signal output by the delay element 212 is delayed by more than one periods with respect to the signal output by the signal selecting unit 200, the delay circuit 238 delays the signal output from the synchronizing delay circuit 232 which is input to the AND gate 236 to correspond to the signal output by the delay element 212 by one period. The first OR gate 242 outputs OR among the signals received from the plurality of AND gates 236 to the waveform forming unit 50 and the logic comparing unit 80 as a timing signal. Further, the first OR gate 242 outputs the OR to the switching gate 250 via the fourth wiring 245.

The switching gate 250 outputs AND between the signal received from the first OR gate 242 via the fourth wiring 245 and the signal received from the loop delay measuring unit 270 to the wiring under test 255. The counter 260 is connected with the wiring under test 255 and counts the number of pulses included in the signal received from the wiring under test 255. Then, the counter 260 outputs the counted number to the loop delay measuring unit 270. The second OR gate 265 outputs OR between the signal received from the switching gate 250 via the wiring under test 255 and the signal received from the loop delay measuring unit 270 to the signal selecting unit 200 via the fifth wiring 267.

The loop delay measuring unit 270 estimates an oscillation frequency of the loop path on the basis of the number of pulses included in the signal transmitted by the wiring under test 255. Then, the loop delay measuring unit 270 obtains delay time for signal transmission of the loop path on the basis of the oscillation frequency of the loop path. Further, the loop delay measuring unit 270 controls the decoder 234 and thus selects one of the plurality of delay elements 212 from which signal is output to the first OR gate 242 via the AND gate 236 and the third wiring 240, that is, selects one of the plurality of delay elements 212 which is to be connected on the loop path. Further, in case of measuring delay time of the wiring under test 255, the loop path measuring unit 270 may output H logic to the synchronizing delay circuit 232 all the time. Then, the loop path measuring unit 270 measures delay time of the loop path in each of two cases of connecting different numbers of delay elements 212 on the loop path and outputs the respective measurement result to the first gate delay estimating unit 170.

On the basis of the difference between delay time of the loop path in the two cases of connecting different numbers of delay elements 212 on the loop path, the first gate delay estimating unit 275 estimates delay time of the delay element(s) 212 which are connected on the loop path in one case and not connected on the loop path in the other case. The memory 280 stores reference values of delay time of each of the delay elements 212 and each of logic circuits connected on the loop path regardless which one of the delay element 212 is connected on the loop path. Here, the logic circuit includes the signal selecting unit 200, the plurality of AND gates 236, the first OR gate 242, the switching gate 250, and the second OR gate 265. The delay ratio estimating unit 285 estimates a ratio of the actual delay time of the delay element 212 estimated by the first gate delay estimating unit 275 to the reference value of delay time of the delay element 212 stored in the memory 280. Here, in case the delay time of the delay element 212 estimated by the first gate delay estimating unit 275 is generated by a plurality of delay elements 212, the delay ratio estimating unit 285 may estimate a ratio of delay time by using delay time which is integer times as large as the reference value of delay time of one delay element 212 stored in the memory 280 as a reference value. Then, the delay ratio estimating unit 285 outputs the estimated ratio of delay time and the delay time of the loop path to the second gate delay estimating unit 290.

On the basis of the delay time of the delay element 212 estimated by the first gate delay estimating unit 170, the second gate delay estimating unit 290 estimates a logic circuit connected on the loop path regardless of whether or not the delay element 212 is connected on the loop path. More specifically, the second gate delay estimating unit 290 may multiply the reference value of delay time of the logic circuit by the ratio of delay time estimated by the delay ratio estimating unit 285 and thus actual delay time of the logic circuit. The wiring delay estimating unit 295 estimates delay time of the wiring under test 255 on the basis of the delay time of the loop path measured by the loop delay measuring unit 270 and the delay time of the delay element 212 and other logic circuit connected on the loop path. More specifically, the wiring delay estimating unit 295 may estimate delay time of the wiring under test 255 by subtracting the delay time of the delay element 212 connected on the loop path and the delay time of other logic circuit connected on the loop path from the delay time of the loop path measured by the loop delay measuring unit 270. By this, it is possible to measure delay time of the wiring under test 255 even in case the timing generating unit 40 includes a plurality of delay elements 212.

Further, the driving voltage control unit 216 controls driving voltages of the plurality of delay elements 212 on the basis of the phase difference between the signal output by the delay element 212f and the signal input by the delay element 212a, which is detected by the phase difference detecting unit 214 and thus fixes the phase of the signal output by each of the delay elements 212. By this, the driving voltage control unit 216 can hold the delay amount of the signal of the delay element 212 constant with good accuracy. Here, the driving voltage control inhibiting unit 218 may inhibit the driving voltage control unit 216 from controlling the driving voltage of each delay element 212 when delay time of the wiring under test 255 is measured. In case fixing the phase of the signal output from each delay element 212 by controlling the driving voltage for each delay element 212, delay time of other logic circuit such as the AND gate 236 becomes irregular if the driving voltage of the logic circuit is not controlled. Thus, an error increases in measurement of delay time of the loop path and it is impossible to accurately measure delay time of the wiring under test 255. However, in case of measuring delay time of the wiring under test 255, it is possible to accurately measure delay time of the wiring under test 255 by inhibiting the driving voltage of the delay element 212 from being controlled.

Further, instead of the driving voltage control inhibiting unit 218 inhibiting the driving voltage control unit 216 from controlling the driving voltage of the delay element 212, the driving voltage control unit 216 may control further a driving voltage of other logic circuit connected on the loop path by the driving voltage of each of the delay elements 212 as well as the driving voltages of the plurality of delay elements 212. Here, other logic circuit includes the signal selecting unit 200, the plurality of AND gates 236, the first OR gate 242, the switching gate 250, and the second OR gate 265. By this, since it is possible to accurately measure delay time of the loop path even during controlling the driving voltage, delay time of the wiring under test 255 can be accurately measured.

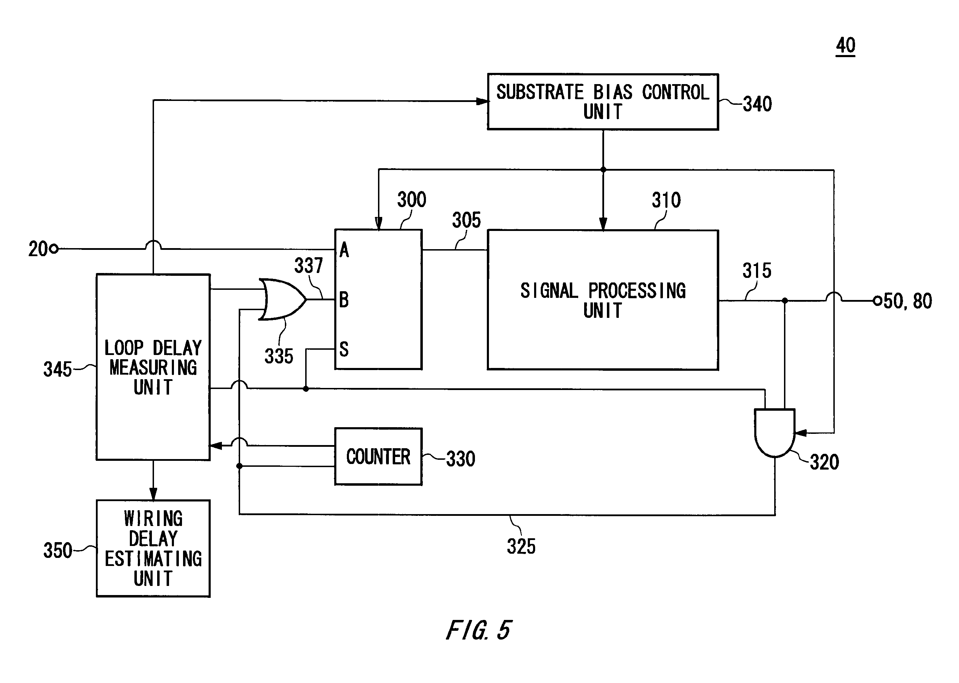

Fig. 5 shows a third example of the configuration of the timing generating unit 40 according to the present embodiment. According to the present example, the timing generating unit 40 measures delay time of a wiring under test 325. The timing generating unit 40 of the first example shown in Fig. 2 estimates the delay time of the wiring under test 150 on the basis of the difference in delay time of the loop path between the cases the delay element 125 is connected on the loop path and is not on the loop path. In the present figure showing the third example, the timing generating unit 40 estimating delay time of the wiring under test 325 without using a delay element is described.

The timing generating unit 40 includes a signal selecting unit 300, a first wiring 305, a signal processing circuit 310, a second wiring 315, a switching gate 320, a wiring under test 325, a counter 330, an OR gate 335, a third wiring 337, a substrate bias control unit 340, a loop delay measuring unit 345, and a wiring delay estimating unit 350. In case of measuring delay time of the wiring under test 325, the timing generating unit 40 uses a loop path on which the wiring under test 325 is provided. Here, the loop path consists of the signal selecting unit 300, the first wiring 305, the signal processing circuit 310, the second wiring 315, the switching gate 320, the wiring under test 325, the OR gate 335, and the third wiring 337.

In case of testing the DUT 15, the signal selecting unit 300 selects a clock signal received from the test control unit 20. Then, the signal selecting unit 300 outputs the selected clock signal to the signal processing circuit 310 via the first wiring 305. The signal processing circuit 310 is connected with the signal selecting unit 300 by the first wiring 305 and generates a timing signal by delaying the clock signal output by the test control unit 20 by a predetermined time. Then, the signal processing circuit 310 outputs the generated timing signal to the waveform forming unit 50 and the logic comparing unit 80.

In the meantime, in case measuring delay time of the wiring under test 325, the signal selecting unit 300 selects a signal received from the OR gate 335. Then, the signal selecting unit 300 outputs the selected signal to the signal processing circuit 310 via the first wiring 305. The signal selecting unit 300 generates a signal by delaying the signal received from the signal selecting unit 300 by a predetermined time. Then, the signal processing circuit 310 outputs the generated signal to the switching gate 320 via the second wiring 315.

The switching gate 320 outputs AND between the signal received from the signal processing circuit 310 via the second wiring 315 and the signal received from the loop delay measuring unit 345 to the wiring under test 325. The counter 330 is connected to the wiring under test 325 and counts the number of pulses included in the signal received from the wiring under test 325. Then, the counter 330 outputs the counted pulse number to the loop delay measuring unit 345. The OR gate 335 outputs OR between the signal received from the switching gate 320 via the wiring under test 325 and the signal received from the loop delay measuring unit 345 to the signal selecting unit 300 via the third wiring 337.

The substrate bias control unit 340 is connected on the loop path and applies a plurality of substrate bias voltages, which are different from each other, to logic circuits, that is, the signal selecting unit 300, the signal processing circuit 310, and the switching gate 320, respectively. The loop delay measuring unit 345 measures delay time for signal transmission of the loop path in case each of a plurality of substrate bias, which are different from each other, is applied to a logic circuit connected on the loop path. Then, the loop delay measuring unit 345 outputs the respective measurement result to the wiring delay estimating unit 350. The wiring delay estimating unit 350 estimates delay time of the wiring under test 325 on the basis of delay time of the plurality of loop paths for the plurality of substrate bias voltages.

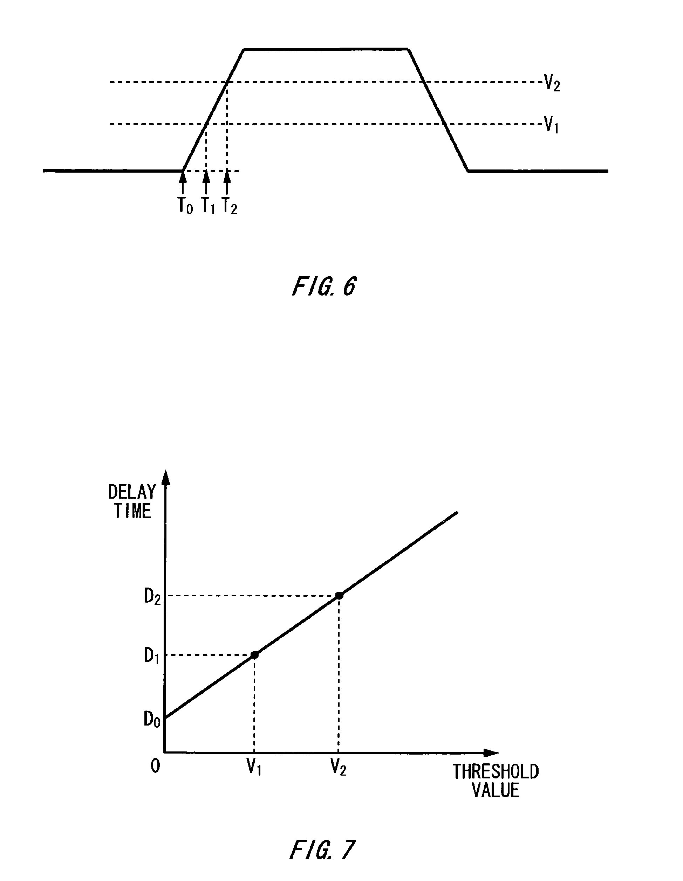

Fig. 6 shows an example of a signal transmitted by a loop path included in the timing generating unit 40 according to the present embodiment. By controlling a substrate bias voltage applied to a logic circuit connected on the loop path, the substrate bias control unit 340 controls a threshold value of voltage of the logic circuit. In case the substrate bias control unit 340 sets the threshold value of voltage of one logic circuit connected on the loop path to V1, it is detected that an input signal of the logic circuit changes at a time T1 if the input signal of the logic circuit changes at a time T0. Therefore, in this case, delay time of the logic circuit is T1-T0. Further, similarly, in case of setting the threshold value of voltage of the logic circuit to V2, delay time of the logic circuit is T2-T0. Here, in case the threshold value of voltage is zero (0), that is, it is detected that the input signal of the logic circuit changes at the time T0, delay time of the logic circuit is zero (0).

Fig. 7 shows a correlation between the result of measurement of delay time of the loop path by the loop delay measuring unit 345 according to the present embodiment and the threshold value of voltage of a logic circuit connected on the loop path. In the present figure, the delay time of the loop path measured by the loop delay measuring unit 345 is D1 in case the threshold value of voltage is V1. Further, the delay time of the loop path measured by the loop delay measuring unit 345 is D2 in case the threshold value of voltage is V2. Then, the wiring delay estimating unit 350 estimates delay time of the wiring under test on the basis of the correlation between the threshold value of voltage and the measured delay time. More specifically, the wiring delay estimating unit 350 estimates an approximate value of the delay time D0 in case the threshold value of voltage is zero (0) by using a straight line passing through two points (V1, D1) and (V2, D2) in the present figure. Here, the estimated D0 is delay time generated by the wirings, that is, the first wiring 305, the second wiring 315, the wiring under test 325, and the third wiring 337. Therefore, in case the wiring length of the wirings except for the wiring under test 325 is very short, D0 estimated by the wiring delay estimating unit 350 is substantially the same as the delay time of the wiring under test 325. By this, the timing generating unit 40 can estimate delay time of the wiring under test 325.

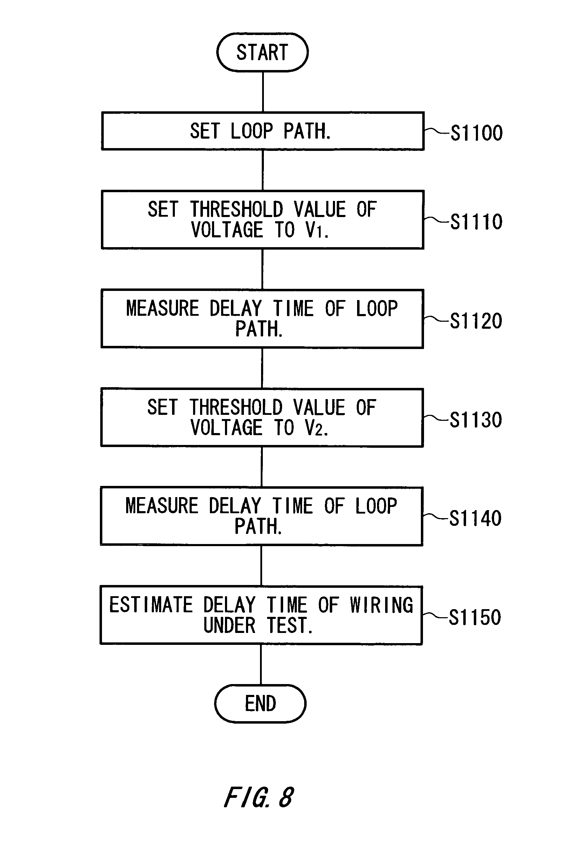

Fig. 8 is a flowchart showing an example of the flow of processing by the third example of the timing generating unit 40 according to the present embodiment. First, the loop delay measuring unit 345 sets a loop path (S1100). More specifically, the loop delay measuring unit 345 controls a signal output to the signal selecting unit 300 and makes the signal selecting unit 300 select a signal output from the OR gate 335. Then, the loop delay measuring unit 345 controls further a signal output to the switching gate 320 and makes the switching gate 320 output a signal output from the signal processing circuit 310 to the wiring under test 325.

Then, the substrate bias control unit 340 applies a substrate bias voltage to each of logic circuits connected on the loop path so that a threshold value of voltage of the logic circuit is set to V1 (S1110). Then, the loop delay measuring unit 345 measures delay time of the loop path (S 1120). More specifically, the loop delay measuring unit 345 outputs pulses to the OR gate 335 and makes the OR gate 335 transmit the pulses to the loop path. Then, the loop delay measuring unit 345 estimates an oscillation frequency of the loop path on the basis of the count result of the number of pulses transmitted by the wiring under test 325 received from the counter 330. Then, the loop delay measuring unit 345 outputs an inverse number of the estimated oscillation frequency as delay time of the loop path.

Then, the substrate bias control unit 340 applies a substrate bias voltage to each logic circuit so that the threshold vale of voltage is set to V2 which is different from V1 (S1130). Then, the loop delay measuring unit 345 measures delay time of the loop path similarly with S1120 (S1140). Then, the wiring delay estimating unit 350 estimates delay time in case the threshold value of voltage is zero (0) on the basis of the threshold value of voltage V 1 and the delay time measured in S 1120 and the threshold value of voltage V2 and the delay time measured in S 1140, and thus measures delay time of the wiring under test 325 (S 1150). Here, the wiring delay estimating unit 350 may estimate delay time of the wiring under test 325 by subtracting the reference value of delay time of each of the wirings other than the wiring under test 325, that is, the first wiring 305, the second wiring 315, and the third wiring 337 from the delay time in case the threshold value is zero (0). By this, it is possible to estimate delay time of the wiring under test 325 with better accuracy. Further, the reference value of delay time may be a value obtained by multiplying a design standard value of delay time per unit length of each wiring by a pattern length of the wiring.

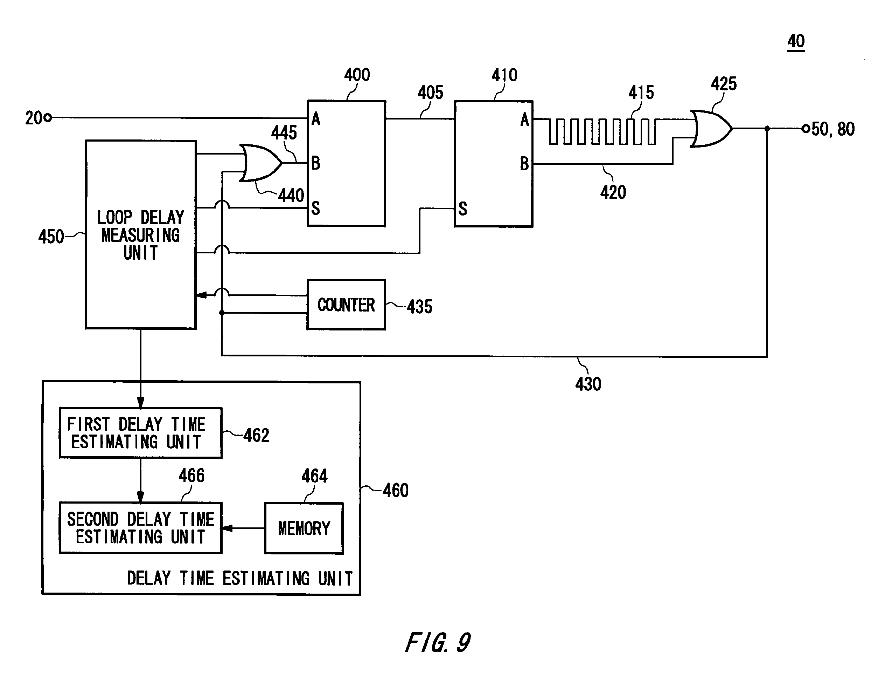

Fig. 9 shows a fourth example of the configuration of the timing generating unit 40 according to the present embodiment. According to the present example, the timing generating unit 40 measures delay time of a wiring under test 415 provided therein. According to the third example shown in Fig. 5, the timing generating unit 40 estimates delay time of the wiring under test 325 on the basis of the delay time of the loop path measured during controlling the substrate bias voltage of the logic circuit connected on the loop path. In the present figure showing the fourth example, the timing generating unit 40 for estimating delay time of the wiring under test 415 without controlling the substrate voltage of a logic circuit is described.

The timing generating unit 40 according to the present example includes a signal selecting unit 400, a first wiring 405, a wiring selecting unit 410, a wiring under test 415, a second wiring 420, a first OR gate 425, a third wiring 430, a second OR gate 440, a fourth wiring 445, a loop delay measuring unit 450, and a delay time estimating unit 460. In case of measuring delay time of the wiring under test 325, the timing generating unit 40 uses a loop path consisting of the signal selecting unit 400, the first wiring 405, one of the wiring under test 415 and the second wiring 420, the third wiring 430, the second OR gate 440, and the fourth wiring 445.

In case of testing the DUT 15, the signal selecting unit 400 selects a clock signal received from the test control unit 20. Then, the signal selecting unit 400 outputs the selected clock signal to the wiring selecting unit 410 via the first wiring 405. The wiring selecting unit 410 is connected with the signal selecting unit 400 by the first wiring 405 and outputs the clock signal received from the signal selecting unit 400 to the first OR gate 425 via one of the wiring under test 415 and the second wiring 420. Then, the first OR gate 425 outputs OR between the signal received from the wiring under test 415 and the signal received from the second wiring 420 to the waveform forming unit 50 and the logic comparing unit 80 as a timing signal.

In the meantime, in case measuring delay time of the wiring under test 415, the signal selecting unit 400 selects a signal received from the second OR gate 440. The wiring selecting unit 410 connects one of the wiring under test 415 and the second wiring 420 on the loop path. Further, the wiring under test 415 produces delay time longer than that of the second wiring 420. For example, the pattern length of the wiring under test 415 is longer than that of the second wiring 420. Then, the wiring selecting unit 410 outputs the signal received from the signal selecting unit 400 to the first OR gate 425 via a wiring connected on the loop path. The first OR gate 425 outputs OR between the signal received from the wiring under test 415 and the signal received from the second wiring 420 to the second OR gate 440 via the third wiring 430.

The counter 435 is connected with the third wiring 430 and counts the number of pulses included in the signal received from the third wiring 430. Then, the counter 435 outputs the counted number to the loop delay measuring unit 450. The second OR gate 440 outputs OR between the signal received from the first OR gate 425 via the third wiring 430 and the signal received from the loop delay measuring unit 450 to the signal selecting unit 400 via the fourth wiring 445. The loop delay measuring unit 450 measures delay time for signal transmission of the loop path in case the wiring under test 415 is connected on the loop path and that in case the second wiring 420 is connected on the loop path. Then, the loop delay measuring unit 450 outputs the respective measurement result to the delay time estimating unit 460.

The delay time estimating unit 460 estimates delay time of the wiring under test 415 on the basis of the delay time of the loop path in case the wiring under test 415 is connected on the loop path and that in case the second wiring 420 is connected on the loop path, which are measured by the loop delay measuring unit 450. The delay time estimating unit 460 includes a first delay time estimating unit 462, a memory 464, and a second delay time estimating unit 466. The first delay time estimating unit 462 estimates delay time by subtracting the delay time of the loop path in case the second wiring 420 is connected on the loop path from the delay time of the loop path in case the wiring under test 415 is connected on the loop path. Here, the delay time estimated by the first delay time estimating unit 462 shows a difference between the delay time of the wiring under test 415 and that of the second wiring 420. Then, the first delay time estimating unit 462 outputs the estimated delay time to the second delay time estimating unit 466. The memory 464 stores a reference value of delay time of the second wiring 420. Here, the reference value of delay time may be, for example, a design standard value of delay time of the second wiring 420. The second delay time estimating unit 466 estimates delay time of the wiring under test 415 by adding the reference value of delay time of the second wiring 420 stored in the memory 464 to the delay time estimated by the first delay time estimating unit 462.

According to the timing generating unit 40 of the present embodiment, it is possible to estimate delay time of the wiring under test 415 on the basis of the delay time of the loop path in each of the cases the wiring under test 415 is connected on the loop path and the second wiring 420 which is a wiring which is different form the wiring under test 415 is connected on the loop path.

Further, it is possible to estimate delay time of the wiring under test 415 with better accuracy by adding the reference value of delay time of the second wiring 420 to the difference in delay time of the cases in comparing with the case where the delay time estimated by the first delay time estimating unit 462 is delay time of the wiring under test 415.

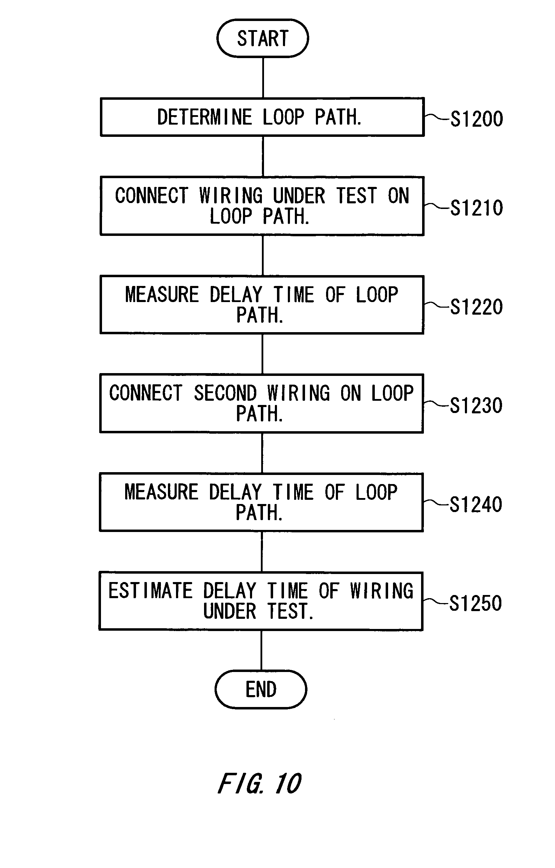

Fig. 10 is a flowchart showing an example of the flow of processing by the fourth example of the timing generating unit 40 according to the present embodiment. First, the loop delay measuring unit 1450 sets a loop path (S1200). More specifically, the loop delay measuring unit 450 controls a signal which is to be output to the signal selecting unit 400 and makes the signal selecting unit 400 select a signal output from the second OR gate 440. Then, the loop delay measuring unit 450 controls the wiring selecting unit 410 to connect the wiring under test 415 on the loop path (S1210). Then, the loop delay measuring unit 450 measures delay time of the loop path (S1220). More specifically, the loop delay measuring unit 450 outputs pulses to the second OR gate 440 and makes the second OR gate 440 transmit the pulses to the loop path. Then, the loop delay measuring unit 450 estimates an oscillation frequency of the loop path on the basis of the result of counting the number of the pulses transmitted by the wiring under test 150 received from the counter 435. Then, the loop delay measuring unit 450 outputs an inverse number of the estimated oscillation frequency as delay time of the loop path. Then, the loop delay measuring unit 450 controls the wiring selecting unit 410 to connect the second wiring 420 on the loop path (S1230). Then, the loop delay measuring unit 450 measures delay time of the loop path similarly with S 1220 (S1240). Then, the delay time estimating unit 460 estimates delay time of the wiring under test 415 on the basis of the delay time estimated in S1220 and the delay time estimated in S1240 (S1250).

In the above, the processes of the timing generating unit included in the testing apparatus measuring delay time of the wiring under test provided therein are described with respect to Figs. 1 to 10. However, the measuring method for the wiring under test according to the present embodiment may be used by other semiconductor device and is not limited to the timing generating unit included in the testing apparatus.

Although the present invention has been described by way of exemplary embodiments, it should be understood that those skilled in the art might make many changes and substitutions without departing from the spirit and the scope of the present invention which is defined only by the appended claims.

### INDUSTRIAL APPLICABILITY

According to the present invention, it is possible to accurately measure delay time of a wiring provided inside a semiconductor device.

## Claims

1. A semiconductor device for measuring delay time of a wiring under test provided therein, comprising:
a loop path on which the wiring under test is provided;
a delay element for delaying an input signal by a predetermined time;
a delay selecting unit for determining whether or not the delay element is connected on the loop path;
a loop delay measuring unit for measuring delay time of the loop path;
a first gate delay estimating unit for estimating delay time of the delay element by subtracting delay time of the loop path in case the delay element is not connected on the loop path from delay time of the loop path in case the delay element is connected on the loop path;
a second gate delay estimating unit for estimating delay time of a logic circuit connected on the loop path on the basis of the delay time of the delay element regardless of whether or not the delay element is connected on the loop path; and
a wiring delay estimating unit for estimating delay time of the wiring under test on the basis of the delay time of the loop path and the delay time of the logic circuit.

2. The semiconductor device as claimed in claim 1, further comprising:
a memory for storing a reference value of delay time of each of the delay element and the logic circuit; and
a delay ratio estimating unit for estimating a ratio of actual delay time of the delay element, which is estimated by the first gate delay estimating unit, to the reference value of delay time of the delay element, wherein
the second gate delay estimating unit estimates actual delay time of the logic circuit by multiplying the reference value of the logic circuit by the ratio estimated by the delay ratio estimating unit.

3. The semiconductor device as claimed in claim 2, wherein
the wiring under test produces delay time larger than the delay time of the delay element.

4. The semiconductor device as claimed in claim 3, wherein
each of wirings other than the wiring under test included in the loop path produces delay time smaller than the delay time of the delay element.

5. The semiconductor device as claimed in claim 4, wherein
the loop path includes:
a path under test which has the wiring under test and is used when delay time of the wiring under test is measured; and
another path which is different from the path under test, and
the semiconductor device further comprises a switching gate for determining whether or not a signal output from the another path is output to the path under test.

6. The semiconductor device as claimed in claim 5, further comprising:
a phase difference detecting unit for detecting phase difference between an output signal of the delay element and an input signal of the delay element;
a driving voltage control unit for controlling a driving voltage of the delay element so that the phase difference can be a predetermined value; and
a driving voltage control inhibiting unit for inhibiting the control of the driving voltage when delay time of the wiring under test is measured.

7. The semiconductor device as claimed in claim 5, further comprising:
a phase difference detecting unit for detecting phase difference between an output signal of the delay element and an input signal of the delay element; and
a driving voltage control unit for controlling a driving voltage of the delay element so that the phase difference can be a predetermined value, wherein
the driving voltage control unit further controls a driving voltage of the logic circuit by the driving voltage of the delay element.

8. A semiconductor device for measuring delay time of a wiring under test provided therein, comprising:
a loop path on which the wiring under test is provided;
a substrate bias control unit for applying a plurality of substrate bias voltages, which are different from each other, to a logic circuit connected on the loop path;
a loop delay measuring unit for measuring delay time of the loop path; and
a wiring delay estimating unit for estimating delay time of the wiring under test on the basis of the delay time of a plurality of loop paths corresponding to the plurality of the substrate bias voltages.

9. A semiconductor device for measuring delay time of a wiring under test provided therein, comprising:
a loop path;
a path selecting unit for connecting one of the wiring under test and another wiring on the loop path;
a loop delay measuring unit for measuring delay time of the loop path; and
a delay time estimating unit for estimating delay time of the wiring under test on the basis of delay time of the loop path in case the wiring under test is connected on the loop path and delay time of the loop path in case the another wiring is connected on the loop path.

10. The semiconductor device as claimed in claim 9, wherein
the delay time estimating unit includes:
a first delay time estimating unit for estimating delay time by subtracting the delay time of the loop path in case the another wiring is connected on the loop path from the delay time of the loop path in case the wiring under test is connected on the loop path;
a memory for storing a reference value of delay time of the another wiring; and
a second delay time estimating unit for estimating delay time of the wiring under test by adding the reference value of delay time of the another wiring to the delay time estimated by the first delay time estimating unit.

11. A testing apparatus for testing a device under test, comprising:
a pattern generating unit for generating a pattern of a test signal which is to be provided to the device under test;
a timing generating unit for generating a timing signal which is an input pulse signal delayed by a predetermined time by a delay element;
a waveform forming unit for forming a waveform of the test signal on the basis of the pattern and the timing signal;
a driver for providing the device under test with the test signal;
a comparator for outputting a logic value which is the result of comparing an output signal output from the device under test in response to the test signal with a reference voltage; and
a logic comparing unit for determining pass/fail of the device under test by comparing the logic value with an expectation value, wherein
the timing generating unit includes:
a loop path on which the wiring under test is provided;
a delay element;
a delay selecting unit for determining whether or not the delay element is connected on the loop path;
a loop delay measuring unit for measuring delay time of the loop path;
a first gate delay estimating unit for estimating delay time of the delay element by subtracting delay time of the loop path in case the delay element is not connected on the loop path from delay time of the loop path in case the delay element is connected on the loop path;
a second gate delay estimating unit for estimating delay time of a logic circuit connected on the loop path on the basis of the delay time of the delay element regardless of whether or not the delay element is connected on the loop path; and
a wiring delay estimating unit for estimating delay time of the wiring under test on the basis of the delay time of the loop path and the delay time of the logic circuit.

12. A method for measuring delay time of a wiring under test provided inside, comprising:
a loop path setting step of setting a loop path on which the wiring under test is provided;
a delay selecting step of determining whether or not the delay element is connected on the loop path;
a loop delay measuring step of measuring delay time of the loop path;
a first gate delay estimating step of estimating delay time of the delay element by subtracting delay time of the loop path in case the delay element is not connected on the loop path from delay time of the loop path in case the delay element is connected on the loop path;
a second gate delay estimating step of estimating delay time of a logic circuit connected on the loop path on the basis of the delay time of the delay element regardless of whether or not the delay element is connected on the loop path; and
a wiring delay estimating step of estimating delay time of the wiring under test on the basis of the delay time of the loop path and the delay time of the logic circuit.

13. A method for measuring delay time of a wiring under test provided inside, comprising:
a loop path setting step of setting a loop path on which the wiring under test is provided;
a substrate bias control step of applying a plurality of substrate bias voltages, which are different from each other, to a logic circuit connected on the loop path;
a loop delay measuring step of measuring delay time of the loop path; and
a wiring delay estimating step of estimating delay time of the wiring under test on the basis of the delay time of a plurality of loop paths corresponding to the plurality of the substrate bias voltages.

14. A method for measuring delay time of a wiring under test provided inside, comprising:
a path selecting step of connecting one of the wiring under test and another wiring on a loop path;
a loop delay measuring step of measuring delay time of the loop path; and
a delay time estimating step of estimating delay time of the wiring under test on the basis of delay time of the loop path in case the wiring under test is connected on the loop path and delay time of the loop path in case the another wiring is connected on the loop path.
